(19) Europäisches Patentamt
European Patent Office
Office européen des brevets

(11) Publication number: 0 029 358 B1

(12) EUROPEAN PATENT SPECIFICATION

(45) Date of publication of patent specification: 28.09.83

(51) Int. Cl.³: G 03 C 1/71, G 03 F 7/02

(21) Application number: 80304098.9

(22) Date of filing: 14.11.80

# (54) Photocrosslinkable compositions and presensitised litho plates.

(30) Priority: 15.11.79 GB 7939570

(43) Date of publication of application:
27.05.81 Bulletin 81/21

(45) Publication of the grant of the patent:
28.09.83 Bulletin 83/39

(84) Designated Contracting States:
BE CH DE FR GB LI

(56) References cited:
None

(73) Proprietor: EASTMAN KODAK COMPANY
Patent Department 343 State Street
Rochester, New York 14650 (US)
(84) BE CH DE FR LI
(73) Proprietor: Kodak Limited
Kodak House Station Road
Hemel Hempstead Hertfordshire (GB)
(84) GB

(72) Inventor: Purbrick, Malcolm Donald
52 Hazeltree Road
North Watford Hertfordshire WD2 5RU (GB)
Inventor: Wagner, Hans Max
4 Dovercourt Gardens
Stanmore Middlesex HA7 4SH (GB)

(74) Representative: Pepper, John Herbert et al,
KODAK LIMITED Patent Department P.O. Box 114
190 High Holborn
London WC1V 7EA (GB)

EP 0 029 358 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England

# Photocrosslinkable compositions and presensitised litho plates

The invention relates to water-coatable, water-developable photocrosslinkable compositions and to presensitised lithographic plates made therefrom.

Negative-working photoresists are photocrosslinkable compositions which become insoluble or less soluble in a solvent when exposed to radiation of the appropriate wavelength. The unexposed areas can thus be dissolved away leaving a resist image. This resist image can have a variety of applications including its use in lithographic printing plates where it can form the inkable image areas.

British Patent Specification 1,603,908 describes a photocrosslinkable composition that is water-developable, i.e. unexposed areas of a coating thereof can be removed with water as developer. However it cannot be coated from a purely aqueous solvent.

Research Disclosure No. 18218 June 1979 published by Industrial Opportunities Ltd., Havant describes a photocrosslinkable composition that is water-coatable but which cannot be developed with a fully aqueous developer. The compositoin comprises an aqueous polymer latex onto whose particles a hydrophobic ethylenically unsaturated polymer and an initiator are loaded from an organic water-miscible solvent, e.g. tetrahydrofuran solution. The hydrophobic photopolymer composition is located in the latex particles and not in the aqueous phase of the latex.

British Specification 2,013,918A describes aqueous photocrosslinkable compositions which are said, at least preferably, to be water-developable containing a latex and a water-soluble or water-dispersible light-sensitive polymer containing at least two reactive moieties per molecule, each moiety being capable of generating active chemical species upon exposure to actinic radiation.

The present invention provides a water-coatable water-developable composition which does not contain such a light-sensitive polymer containing photoactivatable reactive moieties. In contrast, it contains a non-light-sensitive water-soluble addition polymer containing ethylenically unsaturated groups by virtue of which it is photocrosslinkable when used together with a photoinitiator system.

According to the present invention there is provided a water-coatable, water-developable, photocrosslinkable composition comprising:

(1) a non-light-sensitive water-soluble addition polymer containing ethylenically unsaturated groups,

(2) a latex copolymer which renders a dried layer of the composition less water-soluble than a layer of (1) alone, and

(3) a photoinitiator or photoinitiator system.

By the term "water-coatable" we mean that the coating composition from which the composition is coated has a liquid content which is at least 70% by weight water, preferably 100%.

By the term "water-developable" we mean that a coated layer of the composition can be developed using a liquid which is substantially pure water but which may contain small amounts of conventional additives, e.g. surfactants and/or gums.

The advantages of the present invention are that the composition may be coated without the need for ventilation or solvent recovery required for non-aqueous solvents and without fire hazard. Further, since the development is carried out with essentially pure water, again ventilation and possible solvent recovery are not required and disposal of used developer does not lead to any environmental hazards.

The present photocrosslinkable compositions may also contain (4) a water-soluble or water-dispersible ethylentically unsaturated crosslinking agent, for example N,N'-methylene-bis-acrylamide (MBA).

The water-soluble polymer (1) preferably contains quaternary nitrogen groups, for example, quaternary nitrogen groups in which the nitrogen atom forms part of a 5- or 6-membered heterocyclic ring or is located in an open chain.

A preferred class of polymers (1) has repeating units of the formula:

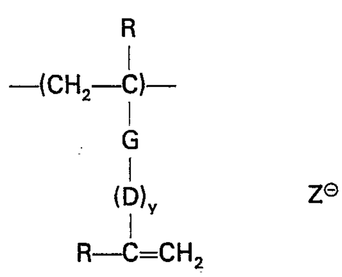

wherein

G is 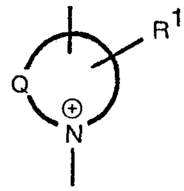 or 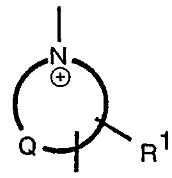

R represents —H or —$CH_3$;
$R^1$ represents an alkyl group or an aryl group;
Q represents atoms which complete a 5- or 6-membered ring;
D represents an alkylene group; an oxyalkylene group; —$CH_2COOCH_2CH_2OOC$—; —$CH_2CONH(CH_2)_bHNOC$—; —$(CH_2)_bOOC$—; or

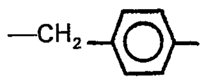 ;

b represents 2 or 3;
y represents 0 or 1; and
$Z^{\ominus}$ is an anion.

A particularly preferred class of the above polymers are those in which the heterocyclic ring is derived from N-vinylimidazole or a substituted N-vinylimidazole.

Polymers (1) containing an open chain quaternary nitrogen atom may, for example, be derived from a dialkylaminoalkylacrylate or methacrylate, e.g. dimethylaminoethylmethacrylate.

The polymer (1) may be a homopolymer or a copolymer. The comonomers may be chosen to confer particular properties of, for example, film forming, degree of water solubility and hydrophobic-hydrophilic balance. Examples of comonomers that may be employed are methyl methylacrylate; 2-hydroxyethyl methacrylate; styrene; acrylonitrile and methacrylonitrie; N-alkyl acrylamides and methacrylamides, e.g. isopropylacrylamide; and, vinyl alkyl ethers. Such copolymers should contain from 25 to 75 molar percent of the photocrosslinkable polymer units.

The latex copolymer (2) preferably comprises at least 50 mole percent, preferably from 60 to 70 mole percent of hydrophobic units derived, for example, from styrene or an alkyl acrylate or methacrylate in which the alkyl group contains 1—4 carbon atoms.

The latex copolymer (2) preferably also contains from 1 to 4 mole percent of units derived from a monomer containing a sulphonic acid group, for example, 2-acrylamido-2-methylpropane sulphonic acid.

The latex copolymer (2) may be a "loadable latex" as defined in British Patent Specification 1,504,950. Such latices may be loaded with a hydrophobic compound, i.e. may have a hydrophobic compound incorporated therein, by the techniques described in said specification or in British Specification 1,504,949.

The photoinitiator system may comprise a single aromatic carbonyl initiator of which many are known, for example, benzoin, benzils and acetophenones.

The photoinitiator system may alternatively comprise a metal carbonyl compound or a metallocene and a trihalomethane derivative.

The trihalomethane derivative may form part of the polymer i.e. the polymer may contain trihalomethane groups, or it may be a separate compound. When a separate compound is used it is preferably soluble in the composition and non-volatile.

It may be advantageous to use an ethylenically unsaturated trihalomethane derivative which will copolymerize with the polymer on exposure to radiation. Examples of such compounds include:

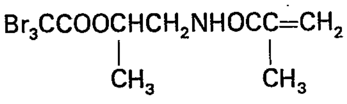 and 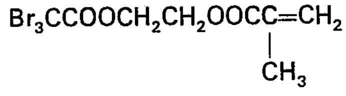

Examples of saturated trihalomethane derivatives which may be used include alkyl esters and amides of tribromoacetic acid and alkyl esters of tribromoethanol. Specific examples include:

$$Br_3CCH_2OH$$

$$Br_3CCOOC_4H_9$$

$$Br_3CCOO(CH_2)_{11}CH_3$$

$Br_3CCH_2COO(CH_2)_{10}CH_3$

$Br_3CCONHC_6H_{13}$

$Br_3CCONH(CH_2)_{11}CH_3$

A copolymerizable trihalomethane derivative may be employed in an amount of from 5 to 80 percent by weight based on the weight of the polymer. Preferably, the trihalomethane derivative is employed in an amount of from 5 to 20 percent by weight.

Suitable metal carbonyl and metallocene compounds include those disclosed in U.K. Patent Specifications Nos. 1,463,816 and 1,495,529, respectively.

A particularly suitable metal carbonyl compound is that represented by the formula:

$$ArM(CO)_3$$

wherein Ar represents a six electron donor ligand e.g. benzene, and M represents a metal of Group VIa of the Mendeleeff periodic table e.g. chromium.

The metal carbonyl or metallocene compound may be used in an amount of from 1 to 20 percent, preferably 2 to 5 percent, by weight based on the weight of the polymer.

The present photocrosslinkable compositions preferably contain 10—25 weight percent latex solids per total solids, preferably 14—20% by weight. The remaining solids will, in substance, comprise the water-soluble polymer and any initiator which is separate from the latex.

The photoinitiator may, as a further alternative, be a co-initiator composition comprising an aromatic carbonyl compound and a tertiary amine. Such compositions are described by Sandner, Osborn and Trecker in J. Polymer Science (Polymer Chemistry Edition) *10* 3173—3181 (1972) and by Ledwith and Purbrick in Polymer *14* 521—522 (October 1973).

A preferred carbonyl compound for use herein, not described in the aforesaid publications disclosing the noted co-initiator compositions is water-soluble 3-(7-methoxy-3-coumarinoyl)-1-methyl-pyridinium *p*-toluene sulphonate.

The photoinitiator system may, as indicated above in connection with metal carbonyl/trihalomethane initiator systems, be incorporated into the photocrosslinkable composition in a number of ways and each component thereof may, if desired, be incoroporated by a different method. The intiator system may be wholly or in part water-soluble in which case it may be simply dissolved in the aqueous phase of the composition.

Alternatively the photoinitiator system may be wholly or in part hydrophobic and may be loaded into latex (2) by the method of British Specification 1,504,949 or 1,504,950 referred to above.

Finally the photoinitiator system may be wholly or in part chemically bonded to the latex copolymer (2). For example, when the initiator system comprises an aromatic carbonyl compound and a tertiary amine, the tertiary amine may form part of the latex (2) by employing a comonomer containing such an amine group i.e. N,N-dimethylaminoethyl methacrylate.

The present photocrosslinkable compositions may contain conventional additives, for example, dyes, pigments, plasticisers or thermal polymerisation inhibitors. They may be coated by conventional means, for example, by whirler coating, roller coating or dip coating.

The present compositions may be photocrosslinked by exposing them uniformly or selectively to actinic radiation, for example, UV radiation or light. The polymer may be sensitised, if necessary, to the type of radiation employed.

Although the present composition may be coated on any support, e.g. glass, metal, paper, resin-coated paper or polymeric film, in a preferred embodiment the support is such that a presensitised lithographic printing plate is formed. Such a support will have a hydrophilic surface onto which the composition is coated so that, after development, the photocrosslinked polymer forms the inkable image areas and the hydrophilic surface revealed forms the non-image areas. A preferred support of this type is aluminium having an anodised surface.

The following Preparations and Examples are added for a better understanding of certain embodiments of the invention. The words "MDP", "Carbowax", "Sage", "Polymatic" and "Ryobi" are trade names or trade marks.

Preparation 1

An amino substituted latex: poly-co(methyl methacrylate, N,N-dimethylaminoethyl methacrylate, 2-hydroxyethyl methacrylate, 2-acrylamido-2-methylpropane-sulphonic acid)

Recipe

In the dropping funnel was placed:

| | |
|---|---|
| Methyl methacrylate | 20 ml |
| N,N-dimethylaminoethyl methacrylate | 31 ml |

| | |
|---|---|
| 2-hydroxyethyl methacrylate | |
| 2-acrylamido-2-methylpropanesulphonic acid (as 10% w/v) aqueous solution adjusted to pH 5) | 10 ml |
| Sodium metabisulphite | 1.0 g |
| Surfactant MDP | 0.5 g |
| Distilled water | 40 ml |

In the reaction flask was placed:

| | |
|---|---|
| Potassium persulphate | 4.8 g |
| Sodium metabisulphite | 1.8 g |
| Surfactant MDP | 0.8 g |
| Distilled water | 100 ml |

(Surfactant MDP is a copolymer of acrylamide and Carbowax 550 acrylate (obtained from Union Carbide) (8:1).)

Procedure

The polymerization was carried out at 80°C in a reaction vessel equipped with stirrer, dropping funnel and nitrogen inlet. Nitrogen blanketing was one of three measures taken against inhibition by oxygen. In addition, the distilled water solvent was boiled and purged with nitrogen before use, and there was a scavenging period of 15 minutes where the contents of the reaction vessel were stirred at 80°C, generating a radical flux from the initiators, before monomer addition started.

The contents of the dropping funnel were added over a period of one hour and the reaction mixture was then stirred for a further four hours. The crude latex was filtered through muslin to remove coagulum before being dialysed against water for 24 hours. The latex was then filtered once more before storage.

Preparation 2

An amino substituted latex of enhanced hydrophobic character: poly-co(methyl methacrylate, N,N-dimethylaminoethyl methacrylate, 2-acrylamido-2-methylpropane sulphonic acid)

Recipe

In the dropping funnel was placed:

| | |
|---|---|
| Methyl methacrylate | 29 ml |
| N,N-dimethylaminoethyl methacrylate | 31 ml |
| 2-acrylamido-2-methylpropanesulphonic acid (as 10% w/v aqueous solution adjusted to pH 5) | 10 ml |
| Sodium metabisulphite | 1.0 g |
| Surfactant MDP | 0.5 g |
| Distilled water | 41 ml |

In the reaction flask was placed:

| | |
|---|---|
| Potassium persulphate | 4.8 g |
| Sodium metabisulphite | 1.8 g |
| Surfactant MDP | 1.2 g |
| Distilled water | 100 ml |

Procedure

The method of preparation was the same as that described in Preparation 1 above.

Preparation 3
A "passive" latex into which photoinitiator components may be loaded: poly-co(methyl methacrylate, 2-hydroxyethyl methacrylate, 2-acrylamido-2-methylpropane sulphonic acid)

Recipe

In the dropping funnel was placed:

| | |
|---|---|
| Methyl methacrylate | 40 ml |
| 2-hydroxyethyl methacrylate | 10 ml |
| 2-acrylamido-2-methyl propane sulphonic acid (as 10% w/v aqueous solution adjusted to pH 5) | 10 ml |
| Sodium metabisulphite | 1.0 g |
| Surfactant MDP | 0.5 g |
| Distilled water | 40 ml |

In the reaction flask was placed:

| | |
|---|---|
| Potassium persulphate | 4.8 g |
| Sodium metabisulphite | 1.8 g |
| Surfactant MDP | 1.2 g |
| Distilled water | 100 ml |

Procedure
The method of preparation was identical with that used for the latex of Preparation 1.

Preparation 4
A photocrosslinkable water-soluble polymer: Poly(methyl methacrylate)-co-(2-methyl-1-vinylimidazole), (monomer mole ratio 3:2) quaternized with chloromethylcarbonyloxyethyl methacrylate
(a) Preparation of polymer: Freshly distilled 2-methyl-1-vinylimidazole (21.6 g) was placed in a 250 ml. three necked round bottomed flask, fitted with a magnetic stirrer, dropping funnel, condenser and a nitrogen gas inlet. Ethanol (75 ml) and acetone (25 ml) was added. The apparatus was placed in a thermostated oil bath set at 70°C. Stirring was started and nitrogen was bubbled continuously through the solution. A.I.B.N. (azo-bis-isobutyronitrile) initiator (0.02 g) was added and stirring and heating were continued for 20 minutes. Then methyl methacrylate (20 g) was added dropwise from the funnel over 20 minutes. Heating, stirring and the passage of nitrogen were continued for 20 hours. The very viscous solution was then diluted with ethanol acetone mixture (3:1 v/v) to 400 ml and the polymer was isolated from the solution by precipitation into water. The colourless fibrous solid was filtered off and the wet polymer cake was freeze dried. 30 g of polymer were collected. N.M.R. spectroscopy showed that the polymer had a monomer ratio of methyl methacrylate to vinylimidazole of 1.6:1. It had a log viscosity number of 34 (1% in ethanol/acetone at 25°C).
$C_{27}H_{40}N_4O_6$ require N, 10.78%, Found 9.6%.
(b) Quaternization of Polymer: The polymer described above (10.32 g) was dissolved in D.M.F. (dimethylformamide) (100 ml) in a 250 ml round bottomed flask, fitted with a magnetic stirrer and condenser. The apparatus was placed in a thermostated oil bath set at 80°C. 2,6-Ditertiary butyl-4-hydroxytoluene (0.2 g) was added, followed by chloromethylcarbonyloxyethyl methacrylate (8.2 g). The solution was heated and stirred for 22 hours. The polymer was then isolated by precipitation into ethyl acetate (2.5 l). It was washed with fresh ethyl acetate, filtered off and dried under vacuum at room temperature to give an off white powder, soluble in water (16 g).

$(C_{43}H_{62}Cl_2N_4O_{14})_n$ requires: Cl, 7.64; N, 6.03%
Found: Cl, 7.15; N, 5.77%

Preparation 5
A photocrosslinkable water-soluble polymer: Polymer of Preparation 4(a) quaternized with N-(2-chloromethylcarbonyloxypropyl)methacrylamide

The method of quaternization was the same as that described in preparation 4(b), but the following quantities were used.

| | |
|---|---|
| Polymer of Preparation 4(a) | 10.32 g |
| D.M.F. | 100 ml |
| N-(2-chloromethylcarbonyloxypropyl)methacrylamide | 8.47 g |
| 2,6-di-tert.butyl-4-hydroxytoluene | 0.2 g |

The polymer was a water soluble pale brown solid (14 g).

$(C_{45}H_{68}Cl_2N_6O_{12})_n$ requires: Cl, 7.43; N, 8.80%
Found: Cl, 7.33; N, 8.38%.

Preparation 6

A photocrosslinkable water-soluble polymer: Poly(styrene)-co-(N-vinylimidazole) quaternized with chloromethylcarbonyloxy ethyl methacrylate

The method of quaternization was the same as that described in preparation 4(b).

The copolymer used was poly(styrene-co-N-vinylimidazole) (1:1).

The following quantities were used:

| | |
|---|---|
| Copolymer | 9.9 g |
| Chloromethylcarbonyloxyethyl methacrylate | 10.3 g |
| D.M.F. | 100 ml |
| 2,6-di-tert.butyl-4-hydroxytoluene | 0.1 g |

The polymer was a pale brown powder, soluble in water (13 g).

$(C_{21}H_{25}ClN_2O_4)_n$ requires: Cl, 8.78; N, 6.92%
Found: Cl, 8.58; N, 7.62%.

Preparation 7

A photocrosslinkable water-soluble polymer: Poly(methyl methacrylate)-co-(dimethylaminoethylmethacrylate) quaternized with chloromethylcarbonyloxyethyl methacrylate

(a) Preparation of the polymer: Methyl methacrylate (20 g), dimethylaminoethylmethacrylate (15.7 g) and ethanol (150 ml) were placed in a 500 ml. three necked round bottomed flask, fitted with a stirrer, nitrogen inlet and condenser. The apparatus was placed in a thermostated oil bath set at 60°C, nitrogen was bubbled through the flask and A.I.B.N. initiator (0.175 g) was added. The solution was heated for 24 hours and the polymer was then isolated by the dropwise addition of the solution to water (2.5 l.). The polymer was washed with water and dried under vacuum (35 g). It had a log viscosity number of 15 ml/g. (1% in ethanol at 25°C).

$(C_{18}H_{31}NO_6)$ require: N, 3.92%
Found: N, 3.52%.

(b) Quaternisation of polymer: The copolymer (10.71 g) was dissolved in D.M.F. (100 ml) in a 250 ml round bottomed flask, fitted with a magnetic stirrer and a condenser. The apparatus was placed in a thermostated oil bath set at 80°C. 2,6-Ditertiary butyl-4-hydroxytoluene (0.2 g) was added followed by chloromethylcarbonyloxyethylmethacrylate (6.18 g). The polymer solution was heated overnight and the polymer was isolated from the solution by precipitation into ethyl acetate (2 l). The polymer was washed with ethyl acetate, and dried under vacuum. It had a log viscosity number of 60 ml/g (1% in ethanol at 25°C).

$(C_{26}H_{42}NO_{10}Cl)$ requires: Cl, 6.29; N, 2.48%
Found: Cl, 4.94; N, 2.20%.

Example 1

In this and later examples the aromatic carbonyl compound referred to as MCMTS was 3-(7-methoxy-coumarinoyl)-1-methylpyridinium-*p*-toluene sulphonate having the formula:

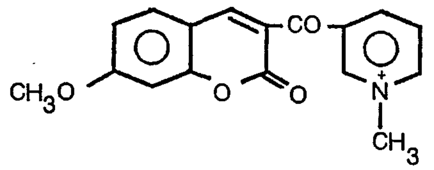

pts.⁻

It may be prepared by a method analogous to the methods described in U.S. Patent No. 4,147,552.

The following coating solution was prepared:

| | |
|---|---|
| Poly(methyl methacrylate-co-2-methyl vinyl imidazole) fully quaternized with chloromethylcarbonyloxyethyl methacrylate (as described in Example 16 of British Specification 1,603,908). | 0.8 g in 6 ml of water |
| MCMTS | 0.1 g |
| Latex of Preparation 1 | 4 ml |
| Water | 12 ml |
| Anionic surfactant | ca. 3 drops |

The above solution was coated onto a 18 × 18 cm grained phosphoric acid anodised foil (unsubbed) on a whirler coater machine at 90 r.p.m. The plate was spun for three minutes at room temperature and then for twelve minutes at 35°C.

Part of the plate was then exposed in a vacuum frame, through a 0.15 density increment step tablet, to four 125w high pressure mercury vapour lamps at a distance of 0.46 m for four minutes.

The exposed coating was then developed in water. After removal of the unexposed areas the non-image areas were desensitised with Kodak Polymatic Finisher. On inking, the last step of the tablet to ink up was recorded as ten.

Example 2

A system based upon the interaction of the amine ethyl p-dimethylaminobenzoate, loaded into a passive latex, with the water-soluble coumarin MCMTS

Loading of the amine into the latex of Preparation 3

A sample of latex of preparation 3 (20) ml) was drawn into a 50 ml syringe and placed on a syringe pump (Sage, model 352). Alongside it was placed a second identical syringe containing a solution of ethyl *p*-dimethylaminobenzoate in dichloromethane (20 ml; see below). By means of the pump, the contents of the syringes were dispensed over a period of thirty minutes and at a constant rate into a beaker containing dichloromethane (10 ml). The ends of the delivery tubes from the syringes were clamped in close proximity and below the surface of the liquid, which was stirred throughout, to optimize blending. The dichloromethane was then removed by evaporation whilst stirring overnight at ambient temperature in a fume cupboard.

In the standard coating solution incorporating an amino substituted latex the amine monomer unit concentration is around $1 \times 10^{-2}$M. The solution of ethyl *p*-dimethylaminobenzoate loaded was designed to match this concentration when the loaded latex was used in place of an equal volume of amino substituted latex in the coating solution. This was achieved by dissolving 0.1696 g of the amine in 25 ml of dichloromethane.

Coating solution

The coating solution comprised:

| | |
|---|---|
| Polymer of Preparation 4 | 0.8 g in 6 ml water |
| Loaded latex of this example | 4 ml |
| MCMTS | 0.1 g |
| N,N'-methylene-bis-acrylamide (Cross-linking agent) | 0.01 g |
| Distilled water | 12 ml |

Coating, exposure and development were carried out as described in Example 1. On a sample given two minutes exposure the last step to ink up was recorded as eight.

Example 3

| | |
|---|---|
| Polymer of Preparation 4 | 1.2 g in 8 ml water |
| Latex of Preparation 1 | 4 ml |
| MCMTS | 0.1 g |
| N,N′-methylene-bis-acrylamide | 0.015 g |
| Distilled water | 10 ml |

The solution was coated, exposed and developed as described in Example 1. A good hard image was obtained. 11 steps were inked up on the step wedge. A control experiment without the N,N′-methylene-bis-acrylamide inked up to 9 steps and was less hydrophobic.

Example 4

Loading of the antioxidant 2,6-ditertiary butyl-4-hydroxytoluene (BHT)

The antioxidant BHT was loaded into an amino substituted latex (Preparation 2) following the procedure described in Example 2. The final BHT concentration in a coating solution otherwise as in Example 3 was 1% w/v. At this level the BHT conferred improved keeping properties on a coating sample stored for two days at 40°C, 50% R.H. A control sample, made in the same way, but without the loaded inhibitor scummed severely under these keeping conditions.

Examples 5, 6 and 7

Lithographic printing plates

Solutions of Example 5, 6 and 7 (see below) were coated on to 38 × 28 cm sections of unsubbed aluminium foil as previously described. In each case the plates were run alongside a Polymatic S plate as control. Run lengths of 20,000, 14,500 and 17,000 were achieved before significant deterioration relative to the S plate was observed.

The coating solutions were as follows:

Example 5

| | |
|---|---|
| Polymer of Preparation 4 | 4 g in 30 ml water |
| Latex of Preparation 2 | 20 ml |
| MCMTS | 0.5 g |
| MBA | 0.05 g |
| Water | 60 ml |

Example 6

| | |
|---|---|
| Polymer of Preparation 5 | 4 g in 27 ml water |
| Latex of Preparation 2 | 13 ml |
| MCMTS | 0.33 g |
| MBA | 0.05 g |
| Water | 33 ml |

Example 7

| | |
|---|---|
| Polymer of Example 1 | 3.75 g in 27 ml water |
| Latex of Preparation 2 | 13 ml |
| MCMTS | 0.33 g |
| MBA | 0.05 g |
| Water | 33 ml |

The printing experiments were carried out on an offset lithographic press, Ryobi 2700, made by Ryobi Ltd., Hiroshima, Japan.

Example 8

A coating solution of the following composition was prepared:

| | |
|---|---|
| MCMTS | 0.1 g |
| Methylene-bis-acrylamide | 0.015 g |
| Polymer of Preparation 7 | 1.2 g |
| Dissolved in water/acetone mixture (4:1) | 12 ml |
| Latex of Preparation 2 | 4 ml |
| Water | 12 ml |

The solution was then exposed for 2 minutes as described in Example 1 and developed in water, desensitized and inked, also as described in Example 1. The last step to ink up was recorded as 8.

**Claims**

1. A water-coatable, water-developable, photocrosslinkable composition comprising:
(1) a non-light-sensitive water-soluble addition polymer containing ethylenically unsaturated groups,
(2) a latex copolymer which renders a dried layer of the composition less water-soluble than a layer of (1) alone, and
(3) a photoinitiator or photoinitiator system.

2. A composition as claimed in Claim 1, which contains (4) a water-soluble or water-dispersible ethylenically unsaturated cross-linking agent.

3. A composition as claimed in Claim 1 or 2 in which the polymer (1) contains quaternary nitrogen groups.

4. A composition as claimed in Claim 3 in which the nitrogen atom forms part of a 5- or 6-membered heterocyclic ring or is located in an open chain.

5. A composition as claimed in Claim 4 in which the polymer (1) contains repeating units of the formula:

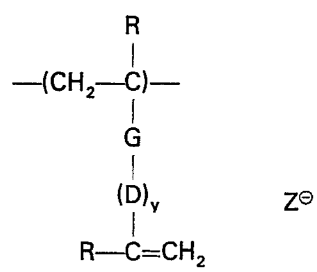

wherein

G is 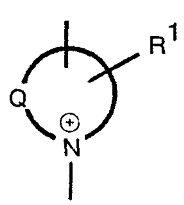 or 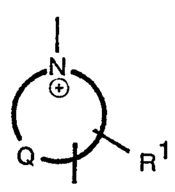

R represents $—H$ or $—CH_3$;
$R^1$ represents an alkyl group or an aryl group;
Q represents atoms which complete a 5- or 6-membered ring;
D represents an alkylene group; an oxyalkylene group; $—CH_2COOCH_2CH_2OOC—$; $—CH_2CONH(CH_2)_bHNOC—$; $—(CH_2)_bOOC—$; or

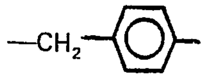 ;

b represents 2 or 3;
y represents 0 or 1; and
$Z^{\ominus}$ is an anion.

6. A composition as claimed in Claim 4 or 5 in which the quaternary nitrogen-containing ring is derived from N-vinylimidazole or a substituted N-vinylimidazole.

7. A composition as claimed in any of Claims 1—6 in which the latex copolymer (2) comprises at least 50 mole percent, preferably 60—70 mole percent, styrene or a 1—4C alkyl acrylate or methacrylate.

8. A composition as claimed in Claim 7 in which the latex copolymer contains from 1 to 4 mole percent of units derived from a monomer containing a sulphonic acid group.

9. A composition as claimed in any of Claims 1—8 in which the photoinitiator system is wholly or in part water-soluble.

10. A composition as claimed in any of Claims 1—8 in which the photoinitiator system is wholly or in part loaded into the latex copolymer (2).

11. A composition as claimed in any of Claims 1—8 in which the photoinitiator system is wholly or in part chemically bonded to the latex copolymer (2).

12. A composition as claimed in any of Claims 1—11 in which the photoinitiator comprises an aromatic carbonyl photoinitiator.

13. A composition as claimed in any of Claims 1—11 in which the photoinitiator system comprises an aromatic carbonyl compound and a tertiary amine.

14. A composition as claimed in Claim 13 in which the carbonyl compound is water-soluble and the tertiary amine comprises tertiary amine groups chemically bonded to the latex copolymer (2).

15. A composition as claimed in any of Claims 1—11 in which the photoinitiator system comprises a metal carbonyl compound or a metallocene and a trihalomethane derivative.

16. A composition as claimed in Claim 15 in which the photoinitiator system is loaded onto the latex copolymer (2).

17. A presensitised lithographic printing plate comprising a support having a hydrophilic surface coated with a layer of a photocrosslinkable composition according to any of Claims 1—16.

## Revendications

1. Composition photoréticulable, apte à être appliquée en couche à partir d'une solution aqueuse et à être dépouillée à l'eau, comprenant:

(1) un polymère d'addition non photosensible, soluble dans l'eau, contenant des groupes à insaturation éthylénique,

(2) un latex copolymère qui rend une couche sèche de la composition moins soluble dans l'eau qu'une couche comprenant seulement (1), et,

(3) un photoamorceur ou un système photoamorceur.

2. Composition conforme à la revendication 1, qui contient: (4) un agent de réticulation à insaturation éthylénique, soluble dans l'eau ou apte à être dispersé dans l'eau.

3. Composition conforme à la revendication 1 ou à la revendication 2, dans laquelle le polymère (1) contient des groupes à azote quaternaire.

4. Composition conforme à la revendication 3, dans laquelle l'atome d'azote fait partie d'un noyau hétérocyclique à 5 ou 6 atomes ou est situé dans une chaîne ouverte.

5. Composition conforme à la revendication 4, dans laquelle le polymère (1) contient des motifs de formule:

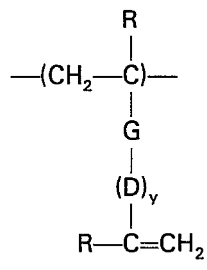

$Z^{\ominus}$

dans laquelle G représente:

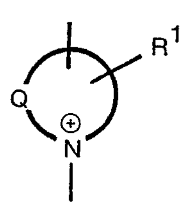

ou

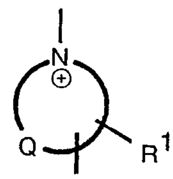

R représente —H ou —$CH_3$;
$R^1$ représente un groupe alkyle ou aryle;
Q représente les atomes nécessaires pour compléter un noyau à 5 ou 6 atomes;
D représente un groupe alkylène, un groupe oxyalkylène, —$CH_2COOCH_2CH_2OOC$—; —$CH_2CONH(CH_2)_bHNOC$—; —$(CH_2)_bOOC$—; ou

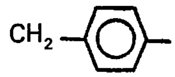 ;

b est égal à 2 ou 3;
y est égal à 0 ou 1; et
$Z^{\ominus}$ est un anion.

6. Composition conforme à la revendication 4 ou 5, dans laquelle le noyau contenant un azote quaternaire est dérivé d'un N-vinylimidazole ou d'un N-vinylimidazole substitué.

7. Composition conforme à l'une quelconque des revendications 1 à 6, dans laquelle le latex copolymère (2) comprend au moins 50 moles pour cent, de préférence 60—70 moles pour cent, de styrène ou d'un acrylate ou d'un méthacrylate d'alkyle contenant de 1 à 4 atomes de carbone.

8. Composition conforme à la revendication 7, dans laquelle le latex copolymère contient de 1 à 4 moles pour cent de motifs dérivés d'un monomère contenant un groupe acide sulfonique.

9. Composition conforme à l'une quelconque des revendications 1 à 8, dans laquelle le système photoamorceur est complètement ou partiellement soluble dans l'eau.

10. Composition conforme à l'une quelconque des revendications 1 à 8, dans laquelle le système photoamorceur est totalement ou partiellement incorporé en tant que charge au latex copolymère (2).

11. Composition conforme à l'une quelconque des revendications 1 à 8, dans laquelle le système photoamorceur est totalement ou partiellement lié chimiquement au latex copolymère (2).

12. Composition conforme à l'une quelconque des revendications 1 à 11, dans laquelle le système photoamorceur est constituté d'un composé aromatique carbonylé.

13. Composition conforme à l'une quelconque des revendications 1 à 11, dans laquelle le système photoamorceur comprend un composé carbonylé aromatique et une amine tertiaire.

14. Composition conforme à la revendication 13, dans laquelle le composé carbonylé est soluble dans l'eau et l'amine tertiaire comprend des groupes amine tertiaire liés chimiquement au latex copolymère (2).

15. Composition conforme à l'une quelconque des revendications 1 à 11, dans laquelle le système photoamorceur comprend un dérivé métal carbonyle ou un métallocène et un dérivé de trihalogénométhane.

16. Composition conforme à la revendication 15, dans la quelle le système photoamorceur est incorporé en tant que charge au latex copolymère (2).

17. Planche d'impression lithographique présensibilisée, comprenant un support ayant une surface hydrophile revêtue d'une couche de composition photoréticulable conforme à l'une quelconque des revendications 1 à 16.

**Patentansprüche**

1. Mit Wasser beschichtbares und Mit Wasser entwickelbares photovernetzbares Material umfassend:
(1) ein nicht-lichtempfindliches, wasserlösliches, äthylenisch ungesättigte Gruppen enthaltendes Additionspolymer,
(2) ein Latex-Copolymer, das eine getrocknete Schicht des Materials weniger wasserlöslich macht als eine ausschließlich aus (1) bestehende Schicht, und
(3) einen Photoinitiator oder ein Photoinitiatorsystem.

2. Material nach Anspruch 1, dadurch gekennzeichnet, daß es
(4) ein wasserlösliches oder in Wasser dispergierbares äthylenisch ungesättigtes Vernetzungsmittel enthält.

3. Material nach Anspruch 1 oder 2, dadurch gekennzeichnet, daß das Polymer (1) quaternäre Stickstoffgruppen enthält.

4. Material nach Anspruch 3, dadurch gekennzeichnet, daß das Stickstoffatom Teil eines 5- oder 6-gliedrigen heterozyklischen Rings ist oder sich innerhalb einer offenen Kette befindet.

5. Material nach Anspruch 4, dadurch gekennzeichnet, daß das Polymer (1) wiederkehrende Einheiten der Formel:

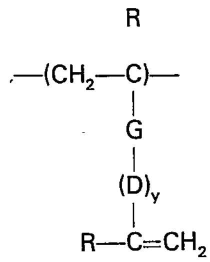

$Z^{\ominus}$

aufweist, worin bedeuten:

G 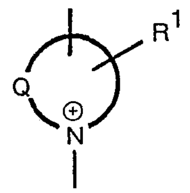 oder 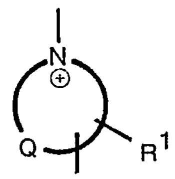

R —H oder —$CH_3$,
$R_1$ eine Alkyl- oder eine Arylgruppe,
Q die zur Vervollständigung eines 5- oder 6-gliedrigen Rings erforderlichen Atome,
D eine Alkylengruppe, eine Oxyalkylengruppe, —$CH_2COOCH_2$—$CH_2OOC$—; —$CH_2CONH(CH_2)_bHNOC$—; —$(CH_2)_bOOC$—; oder

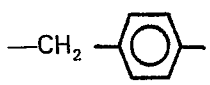 ;

b 2 oder 3, y 0 oder 1 und
$Z^{\ominus}$ ein Anion.

6. Material nach Anspruch 4 oder 5, dadurch gekennzeichnet, daß der quaternäre stickstoffhaltige Ring von N-Vinylimidazol oder einem substituierten N-Vinylimidazol abgeleitet ist.

7. Material nach einem der Ansprüche 1 bis 6, dadurch gekennzeichnet, daß das Latex-Copolymer (2) mindestens 50 Mol-%, vorzugsweise jedoch 60—70 Mol-% Styrol oder eines 1—4C Alkylacrylats oder Methacrylats umfaßt.

8. Material nach Anspruch 7, dadurch gekennzeichnet, daß das Latex-Copolymer 1—4 Mol-% Einheiten enthält, die von einem eine Sulfonsäuregruppe enthaltenden Monomeren abgeleitet sind.

9. Material nach einem der Ansprüche 1 bis 8, dadurch gekennzeichnet, daß das Photoinitiatorsystem ganz oder teilweise wasserlöslich ist.

10. Material nach einem der Ansprüche 1 bis 8, dadurch gekennzeichnet, daß das Photoinitiatorsystem ganz oder teilweise in das Latex-Copolymer (2) eingelagert ist.

11. Material nach einem der Ansprüche 1 bis 8, dadurch gekennzeichnet, daß das Photoinitiatorsystem an das Latex-Copolymer (2) ganz oder teilweise chemisch gebunden ist.

12. Material nach einem der Ansprüche 1 bis 11, dadurch gekennzeichnet, daß der Photoinitiator einen aromatischen Carbonyl-Photoinitiator umfaßt.

13. Material nach einem der Ansprüche 1 bis 11, dadurch gekennzeichnet, daß das Photoinitiatorsystem eine aromatische Carbonylverbindung und ein tertiäres Amin umfaßt.

14. Material nach Anspruch 13, dadurch gekennzeichnet, daß die Carbonylverbindung wasserlöslich ist und das tertiäre Amin tertiäre Aminogruppen aufweist, die an das Latex-Copolymer (2) chemisch gebunden sind.

15. Material nach einem der Ansprüche 1 bis 11, dadurch gekennzeichnet, daß das Photoinitiatorsystem eine Metallcarbonylverbindung oder ein Metallocen und ein Trihalomethanderivat umfaßt.

16. Material nach Anspruch 15, dadurch gekennzeichnet, daß das Latex-Copolymer (2) mit dem Photoinitiatorsystem beladen ist.

17. Eine vorsensibilisierte lithographische Druckplatte mit einem Träger, der eine hydrophile Oberfläche besitzt, auf der sich eine Schicht aus einem photovernetzbaren Material gemäß einem der Ansprüche 1 bis 16 befindet.